# EUROPEAN PATENT APPLICATION

(11) **EP 4 794 482 A2**
(43) Date of publication of application: **19.08.2026**
(21) Application number: 26151511.8
(22) Date of filing: 13.01.2026
(51) Int. Cl.: H10F 30/225, H10F 77/124, H10F 77/14

(54) **AVALANCHE PHOTODIODE**

(30) Priority: 24.01.2025 JP 2025010653
(71) Applicant: Sumitomo Electric Industries, Ltd., Osaka-shi, Osaka 541-0041 (JP)
(72) Inventor: NATSUME, Kazutoshi, Osaka, 541-0041 (JP)
(74) Representative: Grünecker Patent- und Rechtsanwälte PartG mbB

(57) **Abstract**

An avalanche photodiode (100) includes a first semiconductor layer (22) having a p-type conductivity, a barrier layer (24) stacked on a surface of the first semiconductor layer and having a p-type conductivity, a light-absorbing layer (26, 28, 30) stacked on a surface of the barrier layer opposite to the first semiconductor layer and having a p-type conductivity, a second semiconductor layer (32) stacked on a surface of the light-absorbing layer opposite to the barrier layer, a multiplication layer (38) stacked opposite to the light-absorbing layer with respect to the second semiconductor layer, and a third semiconductor layer (52) stacked opposite to the second semiconductor layer with respect to the multiplication layer and having an n-type conductivity. The first semiconductor layer, the barrier layer, the light-absorbing layer, the second semiconductor layer, and the multiplication layer form a first mesa (10). The third semiconductor layer forms a second mesa (13). The second mesa is located inside the first mesa in plan view and protrudes more than the first mesa in a thickness direction. The barrier layer has a doping concentration equal to or higher than a doping concentration of the light-absorbing layer. The second semiconductor layer has a doping concentration equal to or lower than the doping concentration of the light-absorbing layer.

## Description

### CROSS REFERENCE TO RELATED APPLICATIONS

This application claims priority based on Japanese Patent Application No. 2025-010653 filed on January 24, 2025, and the entire contents of the Japanese patent application are incorporated herein by reference.

### TECHNICAL FIELD

The present disclosure relates to an avalanche photodiode.

### BACKGROUND

By providing a mesa in an avalanche photodiode, electric field may be confined (see patent literature 1: Japanese Unexamined Patent Application Publication No. 2012-54478).

### SUMMARY

An avalanche photodiode according to the present disclosure includes a first semiconductor layer having a p-type conductivity, a barrier layer stacked on a surface of the first semiconductor layer and having a p-type conductivity, a light-absorbing layer stacked on a surface of the barrier layer opposite to the first semiconductor layer and having a p-type conductivity, a second semiconductor layer stacked on a surface of the light-absorbing layer opposite to the barrier layer, a multiplication layer stacked on a surface of the second semiconductor layer opposite to the light-absorbing layer, and a third semiconductor layer stacked on a surface of the multiplication layer opposite to the second semiconductor layer and having an n-type conductivity. The first semiconductor layer, the barrier layer, the light-absorbing layer, the second semiconductor layer, and the multiplication layer form a first mesa. The third semiconductor layer forms a second mesa. The second mesa is located inside the first mesa in plan view and protrudes more than the first mesa in a thickness direction. The barrier layer has a doping concentration equal to or higher than a doping concentration of the light-absorbing layer. The second semiconductor layer has a doping concentration equal to or lower than the doping concentration of the light-absorbing layer.

An avalanche photodiode according to an embodiment of the present disclosure includes a first semiconductor layer having a p-type conductivity, a barrier layer stacked on a surface of the first semiconductor layer and having a p-type conductivity, a light-absorbing layer stacked on a surface of the barrier layer opposite to the first semiconductor layer and having a p-type conductivity, a second semiconductor layer stacked on a surface of the light-absorbing layer opposite to the barrier layer, a multiplication layer stacked on a surface of the second semiconductor layer opposite to the light-absorbing layer, and a third semiconductor layer stacked on a surface of the multiplication layer opposite to the second semiconductor layer and having an n-type conductivity. The first semiconductor layer, the barrier layer, the light-absorbing layer, the second semiconductor layer, and the multiplication layer form a first mesa. The third semiconductor layer forms a second mesa. The second mesa is located inside the first mesa in plan view and protrudes more than the first mesa in a thickness direction. The barrier layer has a doping concentration equal to or higher than a doping concentration of the light-absorbing layer. The second semiconductor layer has a doping concentration equal to or lower than the doping concentration of the light-absorbing layer. The light-absorbing layer is less likely to be depleted, and the electric field applied to the light-absorbing layer is reduced. Since the electric field is confined by the second mesa, the electric field at a side surface of the light-absorbing layer is reduced. Thus, the dark current can be reduced. Since a p-type doping concentration of the barrier layer is equal to or higher than the doping concentration of the light-absorbing layer, an energy barrier is formed. Since a p-type doping concentration of the second semiconductor layer is equal to or lower than the doping concentration of the light-absorbing layer, the energy is lowered. Electrons are less likely to move in a direction of the barrier layer, and are more likely to move in a direction of the second semiconductor layer.
In the above embodiment, the light-absorbing layer may have a doping concentration of 1.0 × 10¹⁶ cm⁻³ to 1.0 × 10¹⁹ cm⁻³. The light-absorbing layer is less likely to be depleted, and the dark current can be reduced. Lattice defects can be reduced.
In any one of the above embodiments, in the light-absorbing layer, a portion closer to the barrier layer may have a higher doping concentration and a portion closer to the second semiconductor layer may have a lower doping concentration. The light-absorbing layer is less likely to be depleted, and the electric field applied to the light-absorbing layer is reduced. Thus, the dark current can be reduced. The band tilts from the light-absorbing layer toward the second semiconductor layer. Electrons are more likely to move.
In any one of the above embodiments, the avalanche photodiode may further include a first electric field adjusting layer stacked between the second semiconductor layer and the multiplication layer and having a p-type conductivity, and a second electric field adjusting layer stacked between the multiplication layer and the third semiconductor layer and having an n-type conductivity. The first semiconductor layer, the barrier layer, the light-absorbing layer, the second semiconductor layer, the first electric field adjusting layer, the multiplication layer, and the second electric field adjusting layer may form the first mesa. High electric field is applied to the multiplication layer. Electrons accelerated in the electric field drift to the multiplication layer, and avalanche multiplication occurs. High sensitivity can be obtained. The electric field can be confined by the second mesa. The electric field at side surfaces of the multiplication layer and the light-absorbing layer is reduced. Edge breakdown can be reduced. Thus, the dark current can be reduced.
In any one of the above embodiments, the second semiconductor layer may include a graded layer and a drift layer. The graded layer and the drift layer each may have a p-type conductivity. The graded layer may be stacked on a surface of the light-absorbing layer opposite to the barrier layer. The drift layer may be stacked on a surface of the graded layer opposite to the light-absorbing layer. Each of the graded layer and the drift layer may have a doping concentration equal to or lower than the doping concentration of the light-absorbing layer. Since the band tilts in the graded layer and the drift layer, electrons generated in the light-absorbing layer are more likely to move.
In the above embodiment, the light-absorbing layer may be formed of indium gallium arsenide. Each of the drift layer and the multiplication layer may be formed of aluminum gallium arsenide antimonide. The graded layer may be formed of indium aluminum gallium arsenide antimonide.
In any one of the above embodiments, the avalanche photodiode may further include an electron transit layer stacked between the multiplication layer and the third semiconductor layer. The electron transit layer may be undoped. The electron transit layer and the third semiconductor layer may form the second mesa. Edge breakdown can be reduced. Thus, the dark current can be reduced.

### BRIEF DESCRIPTION OF THE DRAWINGS

FIG. 1 is a plan view illustrating an avalanche photodiode according to a first embodiment.
FIG. 2 is a cross-sectional view illustrating an avalanche photodiode.
FIG. 3 is a diagram illustrating a simulation of a band structure of an avalanche photodiode.
FIG. 4 is a diagram illustrating a simulation of electric field in an avalanche photodiode.
FIG. 5 is a diagram illustrating a simulation of a current.

### DETAILED DESCRIPTION

When the avalanche photodiode is operated, a reverse bias voltage is applied to deplete semiconductor layers of the avalanche photodiode. However, when a light-absorbing layer is depleted, a dark current increases. Thus, an object is to provide an avalanche photodiode capable of reducing a dark current and making a high-speed response.

According to the present disclosure, it is possible to provide an avalanche photodiode capable of reducing a dark current and making a high-speed response.

### [Description of Embodiments of Present Disclosure]

The contents of the embodiments of the present disclosure will be listed and described first.

### [Details of Embodiments of Present Disclosure]

Specific examples of an avalanche photodiode according to an embodiment of the present disclosure will be described below with reference to the drawings. The present disclosure is not limited to these examples, but is defined by the scope of the claims, and is intended to include all modifications within the meaning and scope equivalent to the scope of the claims.

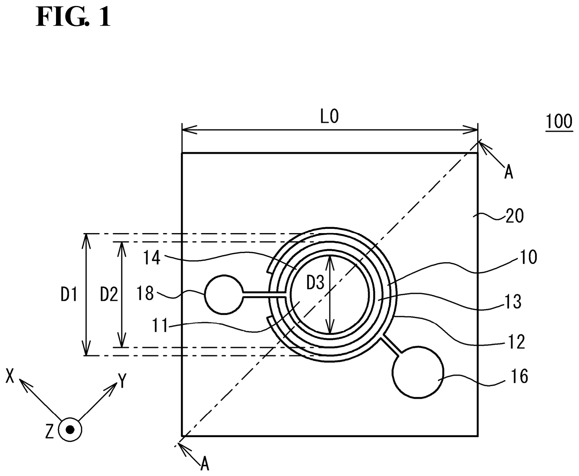

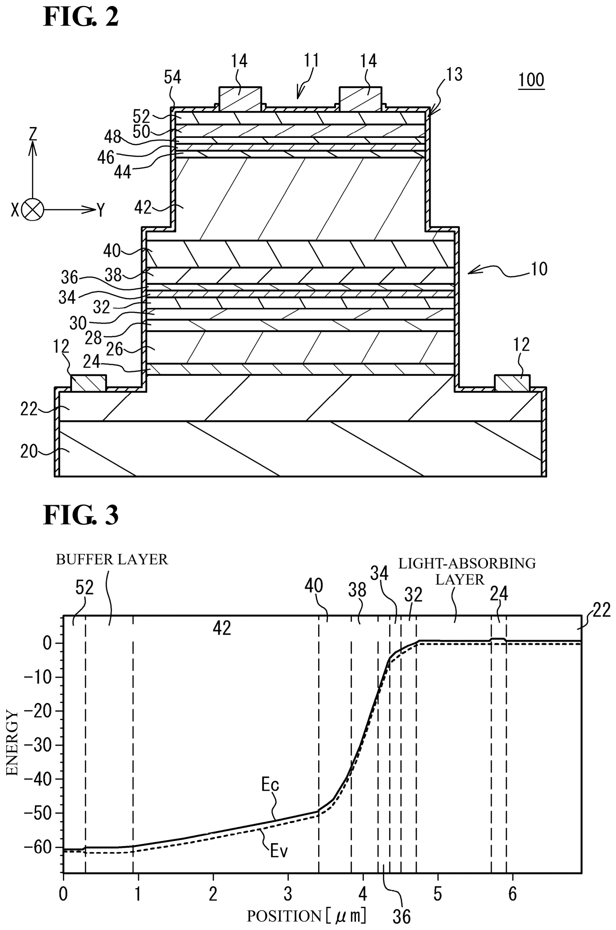

FIG. 1 is a plan view illustrating an avalanche photodiode (APD) 100 according to a first embodiment. An insulating film described later is seen through. FIG. 2 is a cross-sectional view illustrating the avalanche photodiode 100, and shows a cross-section taken along a line A-A of FIG. 1. The avalanche photodiode 100 is used to detect, for example, near-infrared light.

As shown in FIG. 1, the avalanche photodiode 100 includes a mesa 10 (first mesa), a mesa 13 (second mesa), an electrode 12, an electrode 14, a pad 16, a pad 18, and a substrate 20. A planar shape of the substrate 20 is, for example, a square. An upper surface of the substrate 20 is parallel to the XY plane. A length L0 of one side is, for example, 400 µm. The Z-axis is a thickness direction of the substrate 20. The X axis, the Y axis, and the Z axis are orthogonal to each other.

In a plan view, the mesa 10 and the mesa 13 are circular. The mesa 10 and the mesa 13 are arranged concentrically, for example. The mesa 10 is larger than the mesa 13. The mesa 13 is located inside the mesa 10. A diameter D1 of the mesa 10 is, for example, 280 µm. A diameter D2 of the mesa 13 is, for example, 240 µm.

Each of the electrode 12 and the electrode 14 has an annular shape. The electrode 14 is provided on the mesa 13. A portion of the mesa 13 inside the electrode 14 functions as a light receiving region 11. A diameter D3 of the light receiving region 11 is, for example, 200 µm. The electrode 12 is positioned outside the mesa 10 and the mesa 13 and surrounds the mesa 10 and the mesa 13. The pad 16 is electrically connected to the electrode 12. The pad 18 is electrically connected to the electrode 14.

As shown in FIG. 2, the avalanche photodiode 100 includes the substrate 20, a contact layer 22 (first semiconductor layer), an electron barrier layer 24, a light-absorbing layer 26, a light-absorbing layer 28, a light-absorbing layer 30, a graded layer 32 (second semiconductor layer), a drift layer 34 (second semiconductor layer), an electric field adjusting layer 36 (first electric field adjusting layer), a multiplication layer 38, an electric field adjusting layer 40 (second electric field adjusting layer), an electron transit layer 42, a buffer layer 44, a buffer layer 46, a buffer layer 48, a buffer layer 50, and a contact layer 52 (third semiconductor layer).

The contact layer 22 is stacked on a surface of the substrate 20. A central portion of the contact layer 22 protrudes more than an outer peripheral portion of the contact layer 22 in the Z-axis direction. The electron barrier layer 24, the light-absorbing layer 26, the light-absorbing layer 28, the light-absorbing layer 30, the graded layer 32, the drift layer 34, the electric field adjusting layer 36, the multiplication layer 38, the electric field adjusting layer 40, and the electron transit layer 42 are stacked in this order on the central portion of the contact layer 22. The upper portion of the contact layer 22, layers from the electron barrier layer 24 to the electric field adjusting layer 40, and the lower portion of the electron transit layer 42 form the mesa 10.

The central portion of the electron transit layer 42 protrudes more than an outer peripheral portion of the electron transit layer 42 in the Z-axis direction. The buffer layer 44, the buffer layer 46, the buffer layer 48, the buffer layer 50, and the contact layer 52 are stacked in this order in the central portion of the electron transit layer 42 to form the mesa 13. The mesa 10 protrudes more than the upper surface of the substrate 20 in the Z-axis direction. The mesa 13 protrudes more than the mesa 10 in the Z-axis direction. A height of the mesa 13 with respect to an upper surface of the mesa 10 is, for example, 3.2 µm.

The outer peripheral portion of the contact layer 22 is located outside the mesa 10 and the mesa 13 in the XY plane. An insulating film 54 covers the outer peripheral portion of the contact layer 22, the side and upper surfaces of the mesa 10, and the side and upper surfaces of the mesa 13. An opening is provided in a portion of the insulating film 54 covering the outer peripheral portion of the contact layer 22. An opening is provided in a portion of the insulating film 54 covering an upper surface of the mesa 13.

The electrode 12 is provided on the outer peripheral portion of the contact layer 22 and is electrically connected to the contact layer 22 through the opening of the insulating film 54. The electrode 14 is provided on the mesa 13 and is electrically connected to the contact layer 52 through the opening of the insulating film 54.

The substrate 20 is, for example, a semi-insulating semiconductor substrate, and is formed of indium phosphide (InP) doped with iron (Fe). The contact layer 22 is formed of, for example, p+-type indium gallium arsenide ((p+)-InₓGa₁₋ₓAs, x = 0.53). A thickness of the contact layer 22 is, for example, 200 nm to 2000 nm. The p-type semiconductor layer such as the contact layer 22 is doped with beryllium (Be). A doping concentration in the contact layer 22 is, for example, 1.0 × 10¹⁸ cm⁻³ to 5.0 ×10¹⁹ cm⁻³.

The electron barrier layer 24 is formed of, for example, p+-type aluminum indium arsenide ((p+)-AlₓIn₁₋ₓAs, x = 0.48). A thickness of the electron barrier layer 24 is, for example, 20 nm to 500 nm. A Be doping concentration of the electron barrier layer 24 is, for example, 1.0 ×10¹⁷ cm⁻³ to 5.0 ×10¹⁸ cm⁻³.

The light-absorbing layer 26 is formed of, for example, (p+)-InₓGa₁₋ₓAs (x = 0.53). The light-absorbing layer 28 and the light-absorbing layer 30 are formed of, for example, p-InₓGa₁₋ₓAs (x = 0.53). A thickness of the light-absorbing layer 26 is, for example, 200 nm to 1000 nm. A thickness of each of the light-absorbing layer 28 and the light-absorbing layer 30 is, for example, 50 nm to 500 nm. A doping concentration of Be in the light-absorbing layer 26 is, for example, 5.0 ×10¹⁷ cm⁻³ to 2.5 ×10¹⁸ cm⁻³. A doping concentration of Be in the light-absorbing layer 28 is, for example, 1.0 ×10¹⁷ cm⁻³ to 1.0 ×10¹⁸ cm⁻³. A doping concentration of Be in the light-absorbing layer 30 is, for example, 1.0 ×10¹⁶ cm⁻³ to 5.0 ×10¹⁷ cm⁻³.

The graded layer 32 is formed of, for example, p-type indium aluminum gallium arsenide antimonide ((p-)-InAlGaAsSb), and may be a chirped super lattice layer. A thickness of the graded layer 32 is, for example, 50 nm to 500 nm. A doping concentration of Be in the graded layer 32 is, for example, 5.0 × 10¹⁵ cm⁻³ or less. The drift layer 34 is formed of, for example, p-type aluminum gallium arsenide antimonide ((p-)-AlₓGa₁₋ₓAs_{y}Sb_{1-y}, x = 0.85, y = 0.56). A thickness of the drift layer 34 is, for example, 20 nm to 1000 nm. A doping concentration of Be in the drift layer 34 is, for example, 5.0 × 10¹⁵ cm⁻³ or less. The graded layer 32 and the drift layer 34 may be set to the above-described doping concentration by impurities introduced in the manufacturing process without performing intentional doping.

The electric field adjusting layer 36 is formed of, for example, p-AlₓGa₁₋ₓAs_{y}Sb_{1-y} (x = 0.85, y = 0.56). A thickness of the electric field adjusting layer 36 is, for example, 20 nm to 700 nm.

The multiplication layer 38 is formed of, for example, (p-)-AlₓGa₁₋ₓAs_{y}Sb_{1-y} (x = 0.85, y = 0.56). A thickness of the multiplication layer 38 is, for example, 50 nm to 1000 nm. The multiplication layer 38 does not have to be intentionally doped.

The electric field adjusting layer 40 is formed of, for example, n-type AlₓGa₁₋ₓAs_{y}Sb_{1-y} (x = 0.85, y = 0.56). A thickness of the electric field adjusting layer 40 is, for example, 20 nm to 700 nm. The electric field adjusting layer 40 is doped with, for example, gallium and tellurium (GaTe).

The electron transit layer 42 is formed of, for example, undoped AlₓIn₁₋ₓAs (x = 0.48). A thickness of the electron transit layer 42 is, for example, 100 nm to 3500 nm. A doping concentration of the electron transit layer 42 is, for example, 1.0 ×10¹⁶ cm⁻³ or less.

The buffer layer 44, the buffer layer 46, the buffer layer 48, and the buffer layer 50 are formed of, for example, (n+)-AlₓIn₁₋ₓAs (x = 0.48). A thickness of each of the buffer layer 44, the buffer layer 46, and the buffer layer 48 is, for example, 20 nm to 300 nm. A thickness of the buffer layer 50 is, for example, 100 nm to 1000 nm. The buffer layer 44, the buffer layer 46, the buffer layer 48, and the buffer layer 50 are doped with, for example, silicon (Si). A doping concentration in the buffer layer 44 is, for example, 0.1 ×10¹⁷ cm⁻³ to 5.0 ×10¹⁷ cm⁻³. A doping concentration in the buffer layer 46 is, for example, 1.0 ×10¹⁷ cm⁻³ to 5.0 ×10¹⁷ cm⁻³. A doping concentration in the buffer layer 48 is, for example, 0.5 ×10¹⁸ cm⁻³ to 5.0 ×10¹⁸ cm⁻³. A doping concentration in the buffer layer 50 is, for example, 1.0 ×10¹⁸ cm⁻³ to 5.0 ×10¹⁸ cm⁻³.

The contact layer 52 is formed of, for example, (n++)-InₓGa₁₋ₓAs (x = 0.53). A thickness of the contact layer 52 is, for example, 300 nm. A doping concentration of Si in the contact layer 52 is, for example, 2.0 ×10¹⁸ cm⁻³ to 3.0 ×10¹⁹ cm⁻³. The semiconductor layers of the avalanche photodiode 100 may be formed of compound semiconductors other than the above.

The insulating film 54 is a passivation film and is formed of an insulator such as silicon nitride (SiN). A thickness of the insulating film 54 is, for example, 100 nm to 1000 nm. The electrode 12 and the electrode 14 are formed of metal.

### (Manufacturing Method)

For example, layers from the contact layer 22 to the contact layer 52 are epitaxially grown in order on a surface of the substrate 20 by a molecular beam epitaxy (MBE) or a metal organic chemical vapor deposition (MOCVD). The impurity such as Be or Si can be added to the layers by supplying them together with the source gases.

The mesa 13 is formed by etching from the contact layer 52 to a middle portion of the electron transit layer 42. The mesa 10 is formed by etching from the outer peripheral portion of the electron transit layer 42 to a middle portion of the contact layer 22. The insulating film 54 is deposited by plasma enhanced chemical vapor deposition (plasma enhanced CVD). Openings are formed in the insulating film 54 by etching in a portion covering the upper surface of the mesa 13 and a portion covering an upper surface of the contact layer 22. The electrode 12 and the electrode 14 are formed by vacuum deposition and lift-off. The avalanche photodiode 100 is formed.

The avalanche photodiode 100 detects light such as infrared light. When the avalanche photodiode 100 is used, a negative voltage is applied to the electrode 12, and a positive voltage is applied to the electrode 14. The p-type contact layer 22 and the light-absorbing layer, the i-type electron transit layer 42, and the p-type buffer layer and the contact layer 52 are arranged in the Z-axis direction, and form a nip (negative-intrinsic-positive) junction. The depletion region extends in the mesa 10 and the mesa 13.

Light incident from the light receiving region 11 is absorbed by the light-absorbing layer 26, the light-absorbing layer 28, and the light-absorbing layer 30. The light-absorbing layer generates carriers (electron-hole pairs) by absorbing light. Holes move toward the contact layer 22. The electrons are blocked by the electron barrier layer 24 and are less likely to move toward the contact layer 22. The electrons move toward the electrode 14 by the electric field applied to the depletion region, and are output as a photocurrent. The electrons collide with atoms in the multiplication layer 38, thereby generating more carriers. This improves the sensitivity.

FIG. 3 is a diagram illustrating a simulation of a band structure of the avalanche photodiode 100. The horizontal axis represents position of the avalanche photodiode 100 in the Z-axis direction. Position 0 corresponds to a surface of the contact layer 52. As the position value increases, the position moves downward in FIG. 2. The vertical axis represents energy. The dotted line represents energy Ev of a valence band. The solid line represents energy Ec of a conduction band. The dashed line represents boundary of the layer. A simulation is performed with punch-through voltage Vpt as 34 V and breakdown voltage Vbr as 60 V.

The band gaps of the electron barrier layer 24, the graded layer 32, the drift layer 34, the electron transit layer 42, and the like are larger than the band gap of the light-absorbing layer. The energy Ev of the valence band is substantially flat from the contact layer 22 to the light-absorbing layer. The energy Ec of the conduction band of the light-absorbing layer is substantially flat. The energy Ec of the conduction band of the electron barrier layer 24 is higher than the energy Ec of the light-absorbing layer and the contact layer 22. That is, in the conduction band, an energy barrier is formed in the electron barrier layer 24.

From the light-absorbing layer to the contact layer 52, the energy Ec and Ev decrease. In the graded layer 32 and the drift layer 34 adjacent to the light-absorbing layer 30, the energy Ec tilts downward. The energy changes more steeply from the electric field adjusting layer 36 to the electric field adjusting layer 40. The energy changes gradually from the electron transit layer 42 to the contact layer 52.

When the light-absorbing layer absorbs light, electrons are excited to the conduction band. The electrons are blocked by the energy barrier of the electron barrier layer 24 and are less likely to move toward the contact layer 22. Since the energy Ec decreases from the light-absorbing layer toward the contact layer 52, electrons are likely to move from the light-absorbing layer to the contact layer 52. Since the band of valence band tilts, the holes are likely to move toward the contact layer 22.

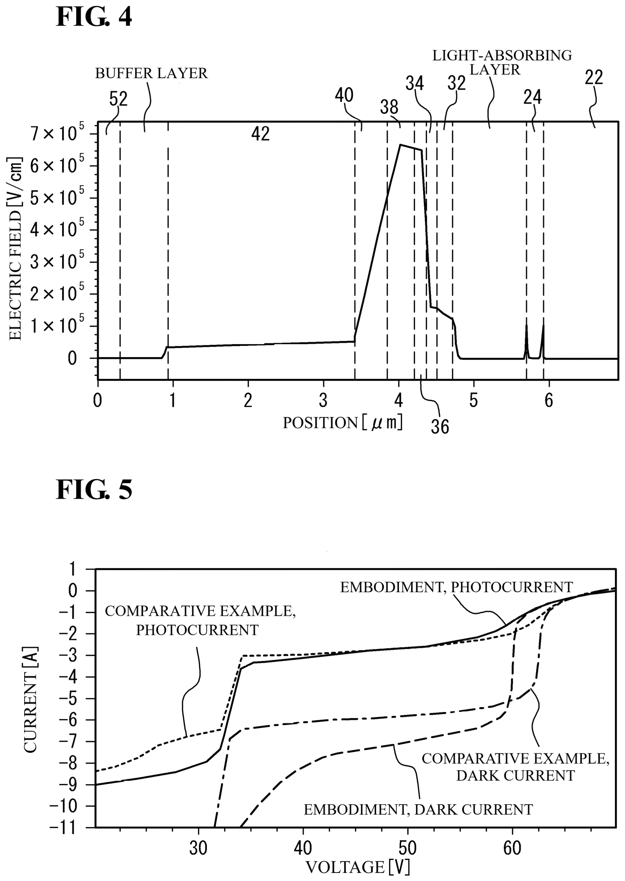

FIG. 4 is a diagram illustrating a simulation of electric field in the avalanche photodiode 100. The horizontal axis represents position. The vertical axis represents electric field. The simulation is performed with Vpt = 35 V and Vbr = 60 V. Higher electric field is applied to the electric field adjusting layer 36, the multiplication layer 38, and the electric field adjusting layer 40 than to other semiconductor layers. In particular, the electric field in the multiplication layer 38 is high. Since electrons accelerated by high electric field enter the multiplication layer 38, avalanche multiplication is possible. The electric field in the light-absorbing layer is almost zero. Since the electric field is hardly applied to the light-absorbing layer having a small band gap, the dark current can be reduced.

FIG. 5 is a diagram illustrating a simulation of a current. The horizontal axis represents voltage applied to the avalanche photodiode 100. The vertical axis represents current. The dotted line represents photocurrent in a comparative example. The dash-dot line represents a dark current in the comparative example. The solid line represents photocurrent in the embodiment. The dashed line represents the dark current in the embodiment. In the comparative example, a light-absorbing layer of undoped InGaAs is provided on a p-type light-absorbing layer. The photocurrent is comparable in the embodiment and in the comparative example. The dark current of the embodiment is lower than the dark current of the comparative example. In the comparative example, the undoped light-absorbing layer is depleted, and thus the dark current increases. The electric field may be increased for extraction of carriers from the light-absorbing layer and high-speed response. As the electric field increases, the dark current increases.

According to the embodiment, the avalanche photodiode 100 includes the p-type light-absorbing layer 26, the light-absorbing layer 28, and the light-absorbing layer 30. The p-type light-absorbing layer is less likely to be depleted than an i-type semiconductor layer. Thus, the electric field applied to the p-type light-absorbing layer is low, and is substantially zero as in the example of FIG. 4. As shown in FIG. 5, the dark current can be reduced. The photocurrent is comparable to the comparative example with the undoped light-absorbing layer. This improves the sensitivity of the avalanche photodiode 100.

As shown in FIG. 2, the avalanche photodiode 100 includes the mesa 10 and the mesa 13. The mesa 13 protrudes more than the mesa 10 in the Z-axis direction and is located inside the mesa 10 in plan view.
The electric field is confined by the mesa 13, and the electric field applied to the side surface of the mesa 10 is reduced. The side surface of the mesa 10 includes the side surface of the light-absorbing layer. Since the electric field at the side surface of the light-absorbing layer is reduced, the dark current can be reduced. As shown in FIG. 1, the mesa 10 protrudes outside the mesa 13 in all directions of the XY plane. The electric field on the entire outer peripheral surface of the light-absorbing layer is reduced. Thus, the dark current can be reduced.

The p-type electron barrier layer 24, three p-type light-absorbing layers, the p-type graded layer 32, and the drift layer 34 are stacked in this order. A doping concentration of the electron barrier layer 24 is equal to or higher than the doping concentration of the light-absorbing layer. As shown in FIG. 3, the energy barrier is formed in the conduction band of the electron barrier layer 24. Electrons generated in the light-absorbing layer cannot cross the energy barrier, and are less likely to move toward the contact layer 22, but are likely to move toward the n-type semiconductor layer.

A doping concentration of each the graded layer 32 and the drift layer 34 is equal to or lower than the doping concentration of the light-absorbing layer, and may be, for example, 1/10 or less or 1/100 or less of the doping concentration of the light-absorbing layer. When the light-absorbing layer, the graded layer 32 and the drift layer 34 are joined, the band tilts downward from the light-absorbing layer toward the graded layer 32 and the drift layer 34. The band structure as shown in FIG. 3 is formed, and carriers are more likely to move. As shown in FIG. 5, the photocurrent becomes sufficiently large. The avalanche photodiode 100 can operate with high sensitivity and at high speed. The electric field may be increased for extracting carriers from the light-absorbing layer and for high-speed response. Since the electric field applied to the light-absorbing layer is low, the dark current can be reduced.

The layers from the contact layer 22 to the electric field adjusting layer 36 are p-type semiconductor layers. The multiplication layer 38 is a semiconductor layer that is not intentionally doped. The layers from the buffer layer 44 to the contact layer 52 are n-type semiconductor layers. The nip junction is formed in the avalanche photodiode 100 along the Z-axis. Since the p-type doping concentration of the electron barrier layer 24 is equal to or higher than the doping concentration of the light-absorbing layer, an energy barrier is formed in the conduction band. The band tilts from the p-type light-absorbing layer 26 to the n-type contact layer 52. Electrons generated in the p-type light-absorbing layer move toward the n-type contact layer 52. The holes move toward the p-type contact layer 22. Photocurrent can be output. No energy barrier is generated in the valence band, and the band is substantially flat from the light-absorbing layer to the contact layer 22. The holes are extracted by the electric field near the boundary between the light-absorbing layer and the graded layer 32, and are likely to move toward the n-type semiconductor layer.

It is only necessary that a semiconductor layer having a p-type doping concentration lower than that of the light-absorbing layer is provided between the light-absorbing layer 30 and the electric field adjusting layer 36. As shown in FIG. 4, the band tilts from the light-absorbing layer to the semiconductor layer, thereby allowing the drift of electrons. For example, as shown in FIG. 2, the graded layer 32 and the drift layer 34 are stacked between the light-absorbing layer 30 and the electric field adjusting layer 36. The doping concentration of each of the graded layer 32 and the drift layer 34 is equal to or lower than the doping concentration of the light-absorbing layer, and may be, for example, 5 ×10¹⁵ cm⁻³ or less, or 1 ×10¹⁶ cm⁻³ or less. The graded layer 32 and the drift layer 34 do not have to be, for example, intentionally doped.

When the doping concentration of the light-absorbing layer is low, the light-absorbing layer is depleted, and the electric field increases. When the doping concentration is high, the light-absorbing layer can deplete slowly, and the electric field in the light-absorbing layer can be lowered. However, lattice defects may occur in the light-absorbing layer and the semiconductor layer stacked thereon. The doping concentration of the light-absorbing layer 26, the light-absorbing layer 28, and the light-absorbing layer 30 may be, for example, 1.0 ×10¹⁶ cm⁻³ to 1.0 ×10¹⁹ cm⁻³. The light-absorbing layer is less likely to be depleted. The electric field applied to the light-absorbing layer is reduced, and thus the dark current can be reduced. Lattice defects can be reduced. The doping concentration of the light-absorbing layer may be 1.0 ×10¹⁷ cm⁻³ or more, 5.0 ×10¹⁷ cm⁻³ or more, 1.0 ×10¹⁸ cm⁻³ or less, or 5.0 ×10¹⁸ cm⁻³ or less.

In the light-absorbing layer, a portion closer to the electron barrier layer 24 may have a higher doping concentration and a portion closer to the graded layer 32 may have a lower doping concentration. For example, the doping concentration may be changed among three light-absorbing layers. The light-absorbing layer 26 is stacked on an upper surface of the electron barrier layer 24. The doping concentration of the light-absorbing layer 26 is higher than the doping concentration of the light-absorbing layer 28 and the light-absorbing layer 30. The doping concentration of the light-absorbing layer 28 is higher than the doping concentration of the light-absorbing layer 30. The light-absorbing layer 30 has the lowest doping concentration among the three light-absorbing layers. As shown in FIG. 3, the band tilts smoothly from the light-absorbing layer 30 to the graded layer 32 and the drift layer 34. As shown in FIG. 4, the electric field is applied near the boundary between the light-absorbing layer and the graded layer 32, but the electric field is hardly applied to the most part of the light-absorbing layer. Thus, the dark current can be reduced. The number of light-absorbing layers may be three or more, or may be three or less. The doping concentration may be gradually changed in the thickness direction in a single light-absorbing layer.

The n-type electric field adjusting layer 36, the multiplication layer 38, and the p-type electric field adjusting layer 40 are stacked between the drift layer 34 and the electron transit layer 42. The electric field adjusting layer 36, the multiplication layer 38, and the electric field adjusting layer 40 are included in the mesa 10. As shown in FIG. 4, the electric field applied to the multiplication layer 38 can be increased. The electrons accelerated by the high electric field drift to the multiplication layer 38, and thereby avalanche breakdown occurs. High sensitivity can be obtained. The electric field is confined by the mesa 13, and the electric field on the side surface of the mesa 10 is lowered. Edge breakdown of the multiplication layer 38 can be reduced. Thus, the dark current can be reduced.

As shown in FIG. 4, the electric field is at a maximum in the multiplication layer 38 and decreases from the multiplication layer 38 to the electric field adjusting layer 36, the drift layer 34, and the graded layer 32. Thus, the electric field in the light-absorbing layer is lowered. Thus, the dark current can be reduced.

As an example, the electron barrier layer 24 is formed of AlInAs. The light-absorbing layer is formed of p-type InGaAs. The drift layer 34, the electric field adjusting layer 36, the multiplication layer 38, and the electric field adjusting layer 40 are formed of AlGaAsSb. The graded layer 32 is formed of InAlGaAsSb. Lattice matching is possible between these layers. As a dopant of the p-type semiconductor layer, for example, Be is used. As a dopant of the n-type semiconductor layer, for example, Si is used.

The electron barrier layer 24 may be formed of InP, AlₓIn₁₋ₓAs, AlₓGa_{y}In_{1-x-y}As, AlAs_{y}Sb_{1-y}, AlₓGa₁₋ₓAs_{y}Sb_{1-y}, or the like, other than AlₓIn₁₋ₓAs_{y}Sb_{1-y}. The light-absorbing layer is formed of a semiconductor having a narrower band gap than the electron barrier layer 24.

The electron transit layer 42 is stacked between the electric field adjusting layer 40 and the buffer layer. The electron transit layer 42 is included in the mesa 13. Since the electric field is confined by the mesa 13, the electric field at the side surface of the mesa 10 is lowered. Thus, the dark current can be reduced. Edge breakdown can also be reduced. The electron transit layer 42 may be thicker than the light-absorbing layer or the like. Since the side surface of the mesa 10 is separated from the contact layer 52 and the electrode 14, the electric field applied to the side surface can be lowered. The dark current can be reduced and the edge breakdown can be reduced. The electron transit layer 42 is undoped, for example. As shown in FIG. 3, the band tilts from the electron transit layer 42 toward the n-type buffer layer and the contact layer 52. Electrons are likely to move toward the contact layer 52.

The embodiment may be applied to an array type avalanche photodiode. In the array-type avalanche photodiode, a plurality of mesas are arranged in a two-dimensional grid, for example. A pair of one mesa 10 and one mesa 13 functions as one photodiode. The photodiodes are separated from each other by the recesses between the mesas. The embodiment may be applied to each photodiode.

Although the embodiments of the present disclosure have been described in detail, the present disclosure is not limited to the specific embodiments, and various modifications and changes can be made within the scope of the gist of the present disclosure described in the claims.

### REFERENCE SIGNS LIST

10, 13 mesa
11 light receiving region
12, 14 electrode
16, 18 pad
20 substrate
22, 52 contact layer
24 electron barrier layer
26, 28, 30 light-absorbing layer
32 graded layer
34 drift layer
36, 40 electric field adjusting layer
38 multiplication layer
42 electron transit layer
44, 46, 48, 50 buffer layer
54 insulating film
100 avalanche photodiode

## Claims

1. An avalanche photodiode comprising:
a first semiconductor layer having a p-type conductivity;
a barrier layer stacked on a surface of the first semiconductor layer and having a p-type conductivity;
a light-absorbing layer stacked on a surface of the barrier layer opposite to the first semiconductor layer and having a p-type conductivity;
a second semiconductor layer stacked on a surface of the light-absorbing layer opposite to the barrier layer;
a multiplication layer stacked on a surface of the second semiconductor layer opposite to the light-absorbing layer; and
a third semiconductor layer stacked on a surface of the multiplication layer opposite to the second semiconductor layer and having an n-type conductivity,
wherein the first semiconductor layer, the barrier layer, the light-absorbing layer, the second semiconductor layer, and the multiplication layer form a first mesa,
wherein the third semiconductor layer forms a second mesa,
wherein the second mesa is located inside the first mesa in plan view and protrudes more than the first mesa in a thickness direction,
wherein the barrier layer has a doping concentration equal to or higher than a doping concentration of the light-absorbing layer, and
wherein the second semiconductor layer has a doping concentration equal to or lower than the doping concentration of the light-absorbing layer.

2. The avalanche photodiode according to claim 1,
wherein the light-absorbing layer has a doping concentration of 1.0 × 10¹⁶ cm⁻³ to 1.0 × 10¹⁹ cm⁻³.

3. The avalanche photodiode according to claim 1 or 2,
wherein, in the light-absorbing layer, a portion closer to the barrier layer has a higher doping concentration and a portion closer to the second semiconductor layer has a lower doping concentration.

4. The avalanche photodiode according to any one of claims 1 to 3 further comprising:
a first electric field adjusting layer stacked between the second semiconductor layer and the multiplication layer and having a p-type conductivity; and
a second electric field adjusting layer stacked between the multiplication layer and the third semiconductor layer and having an n-type conductivity,
wherein the first semiconductor layer, the barrier layer, the light-absorbing layer, the second semiconductor layer, the first electric field adjusting layer, the multiplication layer, and the second electric field adjusting layer form the first mesa.

5. The avalanche photodiode according to any one of claims 1 to 4,
wherein the second semiconductor layer includes a graded layer and a drift layer,
wherein the graded layer and the drift layer each have a p-type conductivity,
wherein the graded layer is stacked on a surface of the light-absorbing layer opposite to the barrier layer,
wherein the drift layer is stacked on a surface of the graded layer opposite to the light-absorbing layer, and
wherein each of the graded layer and the drift layer has a doping concentration equal to or lower than the doping concentration of the light-absorbing layer.

6. The avalanche photodiode according to claim 5,
wherein the light-absorbing layer is formed of indium gallium arsenide,
wherein each of the drift layer and the multiplication layer is formed of aluminum gallium arsenide antimonide, and
wherein the graded layer is formed of indium aluminum gallium arsenide antimonide.

7. The avalanche photodiode according to any one of claims 1 to 6, further comprising:
an electron transit layer stacked between the multiplication layer and the third semiconductor layer,
wherein the electron transit layer is undoped, and
wherein the electron transit layer and the third semiconductor layer form the second mesa.
